# EUROPÄISCHE PATENTSCHRIFT

(11) **EP 2 829 927 B1**
(45) Veröffentlichungstag und Bekanntmachung des Hinweises auf die Patenterteilung: **16.03.2016**
(21) Anmeldenummer: 14002298.9
(22) Anmeldetag: 04.07.2014
(51) Int. Cl.: G05B 19/042, H01R 13/642, H05K 7/14

(54) **Modulare Feldgeräteanschlusseinheit**
Modular field device connection unit
Unité modulaire de raccordement d'appareil de terrain

(30) Priorität: 09.07.2013 DE 102013011377
(43) Veröffentlichungstag der Anmeldung: 28.01.2015
(73) Patentinhaber: ABB Technology AG, 8050 Zürich (CH)
(72) Erfinder: Jacobsson, Peter, 72461 Västerås (SE)
(74) Vertreter: Marks, Frank

(56) Entgegenhaltungen:
- EP-A1- 0 592 712
- DE-A1-102004 056 242
- DE-U1- 29 620 410
- DE-U1- 29 906 583

## Beschreibung

Die Erfindung betrifft eine modulare Feldgeräteanschlusseinheit zur elektrischen Verbindung von Feldgeräten mit einer Steuerungskomponente in einer automatisierungstechnischen Einrichtung.

Das Einsatzgebiet der Erfindung erstreckt sich auf prinzipiell alle Feldgeräte als technische Einrichtungen im Bereich der Automatisierungstechnik, die mit einem Produktionsprozess in direkter Beziehung stehen. Derartige Feldgeräte können sowohl Aktoren, wie Stellglieder oder Ventile, als auch Sensoren, wie Messumformer, in der Fabrik- und Prozessautomation sein. Die Feldgeräte sind mit Hilfe einer Anschlussleitung mit einem übergeordneten Steuerungssystem, meist über einen Feldbus, verbunden. Hierüber werden die Daten ausgetauscht und dienen dann zur Regelung, Steuerung und weiteren Verarbeitung. Häufig verwendete Kommunikationsstandards für Feldbus sind CAN, HART, PROFIBUS oder können auch auf Basis von ETHERNET, Profinet, IP ausgebildet sein.

Darüber hinaus sind diese Feldgeräte, insbesondere 4-20 mA Geräte aber auch solche mit Feldbus, über diese Anschlussleitung energieversorgt.

In der Praxis werden die Anschlussleitung nicht dierekt von dem jeweiligen Feldgerät zu der Steuerungskomponente geführt sondern zunächst individuell vom jeweiligen Feldgerät zu einer Feldgeräteanschlusseinheit, welche dann mit einer Sammelleitung, insbesondere einer Busleitung, mit der Steuerungskomponente verbunden ist. Aus der DE 101 35 980 C1 ist eine Anordnung zum Anschluss von dezentral und prozeßnah angeordneten Feldgeräten an eine entfernte zentrale Einrichtung in einer automatisierungstechnischen Anlage mit einem Verteiler bekannt der mindestens eine Kommunikationsschnittstelle zur Kommunikation mit der entfernten zentralen Einrichtung, eine Mehrzahl von steckbaren Ein-/Ausgabe-Baugruppen und ein vielpoliges Anschlußklemmenfeld zum Anschluß von Feldgeräten aufweist. Die Ein/Ausgabe- Baugruppen weisen eine systemseitige Kommunikationsschnittstelle und eine feldseitige Kommunikationsschnittstelle in derselben Steckebene auf. Die systemseitigen Kommunikationsschnittstellen der E/A-Baugruppen sind mit der Kommunikationsschnittstelle zur Kommunikation mit der zentralen Einrichtung verbunden. Die feldseitigen Kommunikationsschnittstellen der E/A-Baugruppen und das Anschlußklemmenfeld sind an voneinander getrennte Kontakte einer Steckkontaktvorrichtung angeschlossen.

Dabei ist eine konfigurationsbestimmende Steckeinheit vorgesehen, die eine zu der Steckkontaktvorrichtung korrespondierende Steckgegenkontaktvorrichtung und Leiterbrücken zur elektrischen Verbindung voneinander getrennter Kontakte der Steckkontaktvorrichtung derart aufweist, daß jeweils ein Feldgerät mit der feldseitigen Kommunikationsschnittstelle mindestens einer E/A-Baugruppe verbunden ist. Fehlerhafte Bestückungen der Einrichtung mit falschen konfigurationsbestimmenden Steckeinheiten können dabei schwewiegende Fehler in der Feldgeräteanschlusseinheit hervorrufen.

Das Dokument DE 10 2004 056242 A1 betrifft ein modulares erweiterungsfähiges Automatisierungsgerät zur Steuerung und/oder Überwachung technischer Prozesse, dessen Module nebeneinander platzierbar und mittels Anschlusselementen und standardisierten Steckern über einen Bus elektrisch verbindbar sind, wobei um zu gewährleisten, dass die Module auf die richtigen Klemmenblöcke gesteckt werden, die Klemmen der Anschlusselemente mit mechanischen Codiermitteln versehen sind. Diese Codierung der Module wird für jeden Modultyp mittels drehbarer und/oder steckbarer Kunststoffteile oder -tasten, welche zusätzlich in die Anschlusselemente eingebracht werden, verschieden eingestellt.

Der Erfindung liegt daher die Aufgabe zugrunde, eine Feldgeräteanschlusseinheit anzugeben, bei der Fehlkonfigurationen vermieden werden.

Erfindungsgemäß wird diese Aufgabe mit den Mitteln des Patentanspruchs 1 gelöst. Vorteilhafte Ausgestaltungen der Erfindung sind in den rückbezogenen Ansprüchen angegeben.

Die Erfindung geht aus von einer Feldgeräteanschlusseinheit mit einer Grundplatte, auf der eine Mehrzahl von Anschlusselementen zum Anschluss von Verbindungsleitungen mit Feldgeräten und eine Mehrzahl von Steckplätzen zur Aufnahme von jeweils einer Steckeinheit. Dabei können sich die anschließbaren Feldgeräte in ihrem Anschlusstyp und in ihrer Funktion unterscheiden. Gleichartige Feldgeräte gehören einem Feldgerätetyp an.

Korrespondierend zu den jeweils angeschlossenen Feldgeräten weisen die Steckeinheiten verschiedene Schaltungsanordnungen auf, wobei jede der Schaltungsanordnungen zu einem bestimmten Feldgerätetyp gehört. Gleichartige Steckeinheiten gehören einem Steckeinheitentyp an.

Alle Steckeinheiten desselben Steckeinheitentyps weisen eine identische Typkodierung auf, die durch eine Mehrzahl keilförmiger Kodeelemente gebildet ist, welche starr in der Steckeinheit verankert sind.

Die Keilspitzen der keilförmigen Kodeelemente weisen in Steckrichtung des Steckplatzes auf der Grundplatte und sind parallel zur Ebene der Grundplatte, also quer zur Steckrichtung, unter Bildung einer Auflagefläche abgeflacht. Die Keilspitzen sind demnach stumpf.

Darüber hinaus sind die keilförmigen Kodeelemente der Steckeinheiten asymmetrisch ausgebildet, wobei eine in die Keilspitze mündende Seitenfläche jedes Kodeelements in Steckrichtung ausgerichtet ist.

Jeder Steckplatz weist eine Mehrzahl keilförmiger Kodeelemente auf, welche zwischen zwei gegenüberliegenden Anschlägen um eine Drehachse beweglich gelagert sind und deren Keilspitzen in initialer Ruhestellung mittig zwischen den Anschlägen ausgerichtet sind. Die Keilspitzen sind unter Bildung einer Auflagefläche abgeflacht, wobei die Auflagefläche in initialer Ruhestellung parallel zur Ebene der Grundplatte, also quer zur Steckrichtung, ausgerichtet ist.

Beim erstmaligen Stecken einer Steckeinheit auf einen Steckplatz werden die beweglichen Kodeelemente des Steckplatzes um ihre Drehachse in Abhängigkeit von der Ausrichtung des korrespondierenden keilförmigen Kodeelements der Steckeinheit an den Anschlag verschwenkt, der der Keilspitze des starren Kodeelements der Steckeinheit gegenüber liegt, und verbleibt in dieser Lage. Dadurch erfährt der Steckplatz eine initiale Kodierung, die eine ausschließliche Bestückung mit einer Steckeinheit desselben Steckeinheitentyps erlaubt.

Nach der initiale Kodierung sind nur noch Steckeinheit desselben Steckeinheitentyps auf dem Steckplatz bestückbar, weil sich nur bei Steckeinheiten desselben Steckeinheitentyps die Flanken der korrespondierenden keilförmigen Kodeelemente der Steckeinheit und des Steckplatzes ergänzen. Bei Steckeinheiten eines anderen Steckeinheitentyps trifft die Auflagefläche mindestens eines Kodeelements der Steckeinheit auf die Auflagefläche mindestens eines Kodeelements des Steckplatzes. Folglich läßt sich eine Steckeinheit falschen Steckeinheitentyps nicht auf einen für einen anderen Steckeinheitentyp kodierten Steckplatz aufstecken.

Die Erfindung wird nachstehend anhand eines Ausführungsbeispiels näher erläutert. Die dazu erforderlichen Zeichnungen zeigen:
- Figur 1: eine perspektivische Darstellung einer Feldgeräteanschlusseinheit
- Figur 2: eine perspektivische Darstellung einer Feldgeräteanschlusseinheit mit einer gezogenen Steckeinheit
- Figur 3: eine perspektivische und eine geschnittene Darstellung einer Steckeinheit mit einer Kodiereinrichtung im initialen Zustand
- Figur 4: eine perspektivische und eine geschnittene Darstellung einer Steckeinheit mit einer Kodiereinrichtung während des steckenden Kodiervorganges
- Figur 5: eine perspektivische und eine geschnittene Darstellung einer gesteckten Steckeinheit mit einer kodierten Kodiereinrichtung
- Figur 6: eine perspektivische und eine geschnittene Darstellung einer unpassenden Steckeinheit mit einer kodierten Kodiereinrichtung
- Figur 7: eine perspektivische Darstellung einer Steckeinheit mit Kodiermitteln
- Figur 8: eine perspektivische Detaildarstellung einer kodierten Kodiereinrichtung
- Figur 9: eine perspektivische Detaildarstellung einer initialen Kodiereinrichtung
- Figur 10: eine geschnittene Detaildarstellung einer kodierten Kodiereinrichtung
- Figur 11: eine teilweise geschnittene Detaildarstellung einer kodierten Kodiereinrichtung
- Figur 12: eine teilweise geschnittene Detaildarstellung einer initialen Kodiereinrichtung

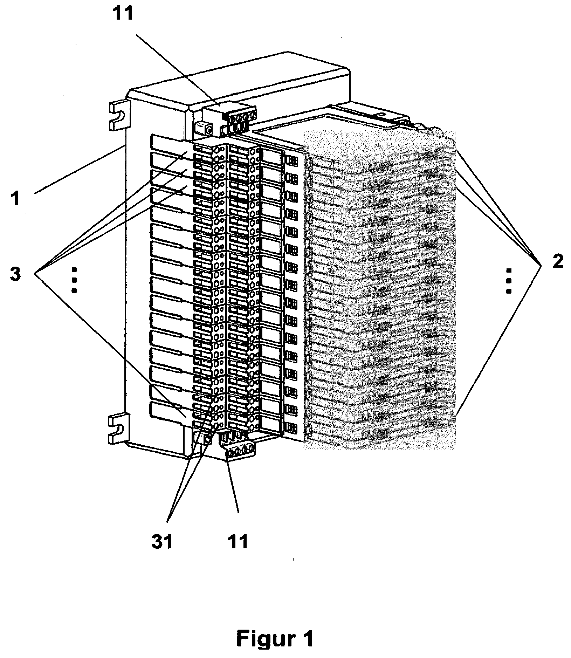

In der Figur 1 ist eine Feldgeräteanschlusseinheit mit einer Grundplatte **1,** auf der eine Mehrzahl von Anschlusselementen **3** zum Anschluss von Verbindungsleitungen mit Feldgeräten und eine Mehrzahl von Steckplätzen zur Aufnahme von jeweils einer Steckeinheit **2** perspektivisch dargestellt. Jede Steckeinheit **2** ist einem Anschlusselement **3** zugeordnet. Die Anschlusselemente **3** weisen Schraubklemmen **31** zum Anschluss von Verbindungsleitungen mit Feldgeräten auf.

Darüber hinaus ist die Grundplatte **1** mit weiteren Schraubklemmen **11** zum Anschluss von Verbindungsleitungen mit einer übergeordneten Steuerungskomponente ausgerüstet.

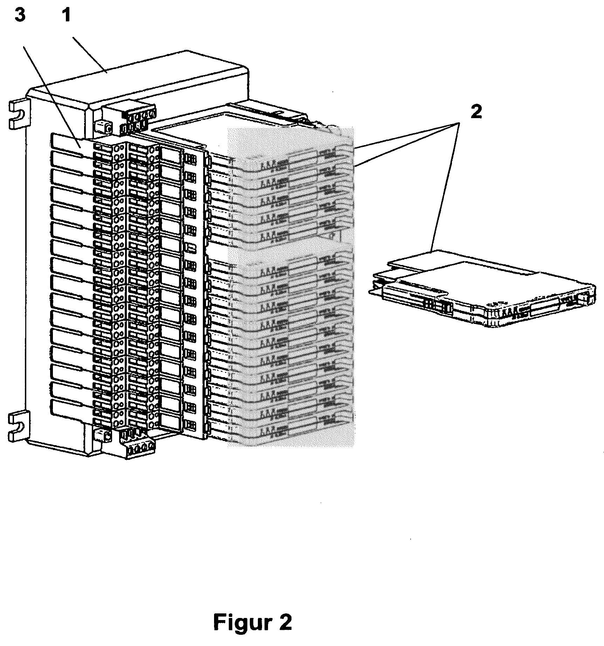

In der Figur 2 ist unter Verwendung gleicher Bezugszeichen für gleiche Mittel eine Feldgeräteanschlusseinheit perspektivisch dargestellt, bei der eine Steckeinheit **2** gezogen ist.

Korrespondierend zu den jeweils angeschlossenen Feldgeräten weisen die Steckeinheiten **2** verschiedene Schaltungsanordnungen auf, wobei jede der Schaltungsanordnungen zu einem bestimmten Feldgerätetyp gehört. Dabei können sich die anschließbaren Feldgeräte in ihrem Anschlusstyp und in ihrer Funktion unterscheiden. Gleichartige Feldgeräte gehören einem Feldgerätetyp an.

Gleichartige Steckeinheiten **2** gehören einem Steckeinheitentyp an. Steckeinheiten **2** desselben Steckeinheitentyps dürfen an demselben Steckplatz ersatzbestückt werden. So ist gewährleistet, dass nur eine Steckeinheit **2** desjenigen Steckeinheitentyps elektrisch mit einem Feldgerät verbunden wird, die zu dessen Feldgerätetyp gehört. Eine Steckeinheit **2** ist dann mit dem Feldgerät verbunden, wenn sie vollständig einegsteckt und mit dem zugehörigen Anschlusselement **3** verbunden ist.

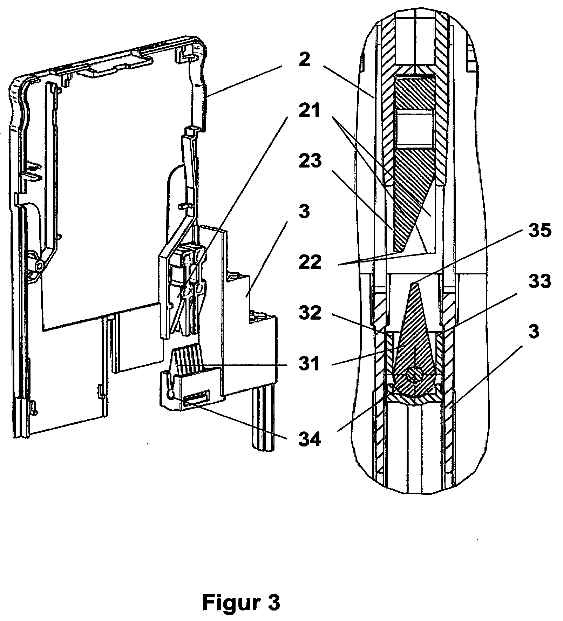

In der Figur 3 sind eine perspektivische und eine vergrößerte, geschnittene Darstellung einer geöffneten Steckeinheit **2** in Beziehung zu einem korrespondierenden Anschlusselement **3** im Umfang der erfindungswesentlichen Elemente gezeigt. Alle Steckeinheiten **2** desselben Steckeinheitentyps weisen eine identische Typkodierung auf, die durch eine Mehrzahl keilförmiger Kodeelemente **21** gebildet ist, welche starr in der Steckeinheit **2** verankert sind.

Die Keilspitzen der keilförmigen Kodeelemente **21** weisen in Steckrichtung des Steckplatzes auf der Grundplatte **1** und sind parallel zur Ebene der Grundplatte **1**, also quer zur Steckrichtung, unter Bildung einer Auflagefläche **22** abgeflacht.

Darüber hinaus sind die keilförmigen Kodeelemente **21** der Steckeinheiten **2** asymmetrisch ausgebildet, wobei eine in die Keilspitze mündende Seitenfläche **23** jedes Kodeelements **21** in Steckrichtung ausgerichtet ist.

Die individuelle Kodierung jedes Steckeinheitentyps ist durch ein vorgegebenes Muster von wechselseitig ausgerichteten Seitenflächen **23** jedes Kodeelements **21** gebildet.

Jeder Steckplatz, gekennzeichnet durch ein Anschlusselement **3**, weist eine Mehrzahl keilförmiger Kodeelemente **31** auf, welche zwischen zwei gegenüberliegenden Anschlägen **32** und **33** um eine Drehachse **34** beweglich gelagert sind und deren Keilspitzen in initialer Ruhestellung mittig zwischen den Anschlägen **32** und **33** ausgerichtet sind. Die Keilspitzen sind unter Bildung einer Auflagefläche **35** abgeflacht, wobei die Auflagefläche **35** in initialer Ruhestellung parallel zur Ebene der Grundplatte **1**, also quer zur Steckrichtung, ausgerichtet ist.

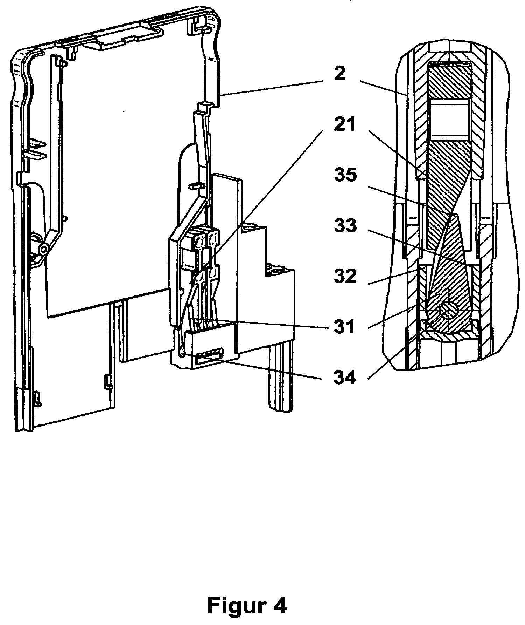

Unter Verwendung gleicher Bezugszeichen für gleiche Mittel ist in Figur 4 eine perspektivische und eine vergrößerte, geschnittene Darstellung einer geöffneten Steckeinheit **2** in Beziehung zu einem korrespondierenden Anschlusselement **3** im Umfang der erfindungswesentlichen Elemente während der initialen Kodierung des Steckplatzes auf einen Steckeinheitentyp gezeigt.

Beim Einstecken der Steckeinheit **2** erfassen deren keilförmigen Kodeelemente **21** die in neutraler Mittelstellung stehenden keilförmiger Kodeelemente **31** am Steckplatz an deren Auflagefläche **35** und verschwenken die keilförmiger Kodeelemente **31** um ihre Drehachse **34** bis zu einem der Anschläge **32** und **33.**

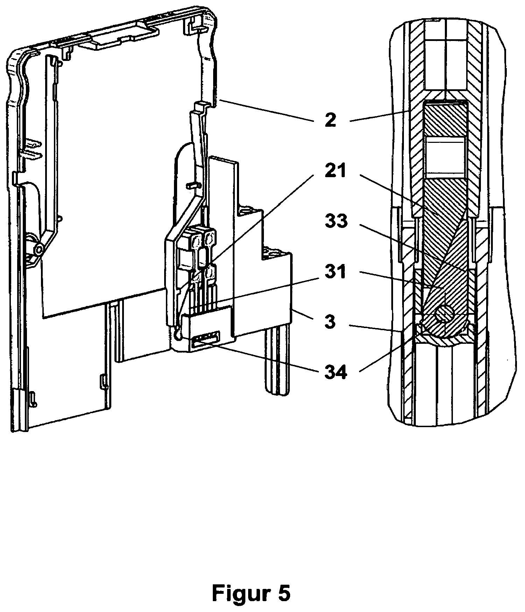

Unter Verwendung gleicher Bezugszeichen für gleiche Mittel ist in Figur 5 der Abschluss des initialen Kodiervorganges dargestellt. Die Steckeinheit **2** ist vollständig eingesteckt. Die keilförmigen Kodeelemente **31** am Steckplatz sind durch die keilförmigen Kodeelemente **21** der Steckeinheit **2** bis an einen Anschläge **32** und **33** verschwenkt. Damit ist der individuelle Kodiervorgang dieses Steckplatzes auf den Steckeinheitentyp der jeweiligen Steckeinheit **2** abgeschlossen.

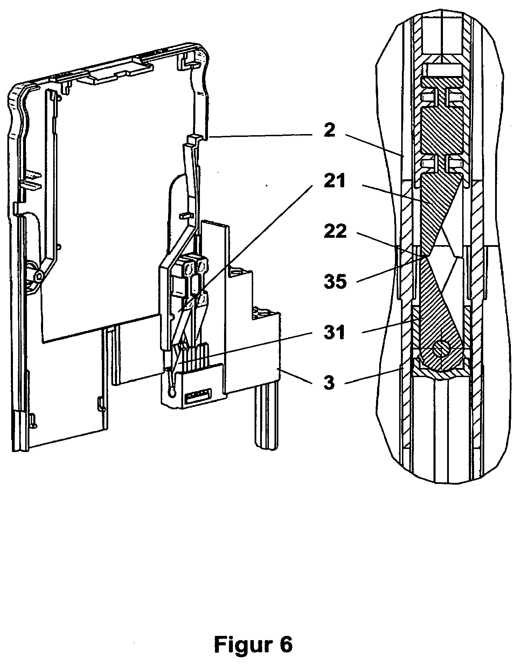

In der Figur 6 ist unter Verwendung gleicher Bezugszeichen für gleiche Mittel ein auf einen Steckeinheitentyp kodierter Steckplatz gezeigt, der fehlerhaft mit einer Steckeinheit **2** eines anderen Steckeinheitentyps bestückt werden soll. Die Bestückung wird dadurch verhindert, dass mindestens ein keilförmiges Kodeelemente **21** der Steckeinheit **2** auf mindestens ein keilförmiges Kodeelement **31** am Steckplatz trifft. Dabei stößt die Auflagefläche **22** des mindestens einen keilförmigen Kodeelements **21** der Steckeinheit **2** auf die Auflagefläche **35** des mindestens einen keilförmigen Kodeelements **31** am Steckplatz und verhindert sicher das weitere Einstecken der Steckeinheit **2** und somit auch die fehlerhafte elektrische Kontaktierung der Steckeinheit **2** mit dem korrespondierenden Anschlusselement **3** und dem Feldgerät.

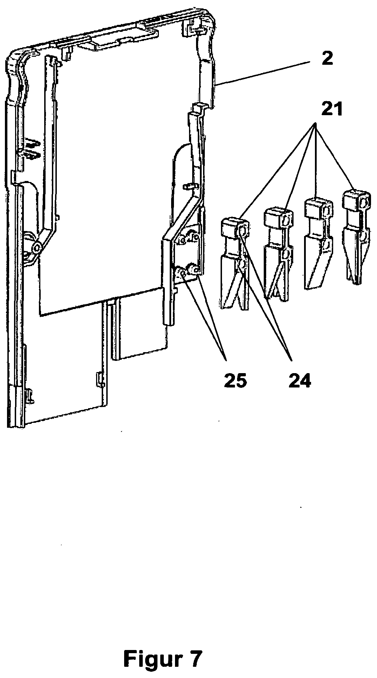

In der Figur 7 ist eine perspektivische Darstellung einer Steckeinheit **2** mit verschiedenen keilförmigen Kodeelementen **21** gezeigt. Die keilförmigen Kodeelemente **21** sind als aufreihbare Elemente ausgeführt, die wahlweise entsprechend dem zu kodierenden Steckeinheitentyp kombinierbar sind. Die verschiedenen Kodeelemente **21** weisen ein oder mehrere Keilelemente optisch verschiedener Keilbreiten auf.

In bevorzugter Ausführungsform ist ein keilförmiges Kodeelement **21** ausgebildet, drei Keilelemente gleicher Keilbreite aufzunehmen. Je nach Orientierung der Keilelemente eines haben die keilförmigen Kodeelemente **21** unterschiedliche Formen und damit unterschiedliche Kodes. Dabei erscheinen aufeinanderfolgende Keilelemente gleicher Orientierung optisch als verschiedene Keilbreiten.

Jedes keilförmige Kodeelement **21** ist wie in der Figur 7 dargestellt oder um 180 Grad um die Längsachse gedreht in die Steckeinheit **2** einsetzbar. Mit zwei aus den vier dargestellten keilförmigen Kodeelementen **21** pro Steckeinheit **2** sind bereits 64 verschiedene Steckeinheitentypen kodierbar.

Dazu weisen die keilförmigen Kodeelemente **21** Ausnehmungen **24** auf, in die Erhebungen **25** der Steckeinheit **2** eingreifen.

In der Fertigung werden die beiden ausgewählten keilförmigen Kodeelemente **21** entsprechend dem zu kodierenden Steckeinheitentyp in die Steckeinheit **2** eingesetzt und konfektioniert.

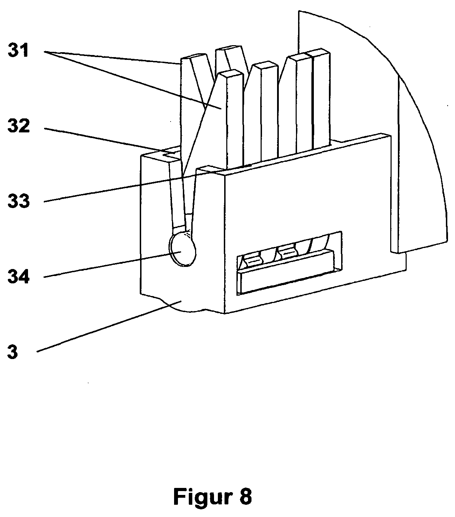

In der Figur 8 ist unter Verwendung gleicher Bezugszeichen für gleiche Mittel eine perspektivische Detaildarstellung einer kodierten Kodiereinrichtung des Anschlusselements **3** vergrößert dargestellt. Zwischen den beiden Anschlägen **32** und **33** sind die keilförmigen Kodeelemente **31** am Steckplatz über eine Drehachse **34** schwenkbar. In der kodierten Ausführung gemäß Figur 8 liegen zwei keilförmige Kodeelemente **31** am Anschlag **32** und vier keilförmige Kodeelemente **31** am Anschlag 33 an. Die in dieser Ausführungsform gezeigten sechs keilförmigen Kodeelemente **31** korrespondieren mit den zwei aus vier dargestellten keilförmigen Kodeelementen **21** mit jeweils drei Keilelementen der Steckeinheit **2** aus Figur 7.

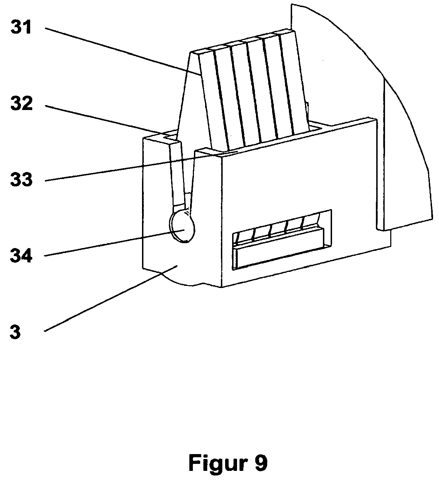

In der Figur 9 ist unter Verwendung gleicher Bezugszeichen für gleiche Mittel eine perspektivische Detaildarstellung einer initialen, also noch nicht kodierten Kodiereinrichtung des Anschlusselements **3** vergrößert dargestellt. Alle keilförmigen Kodeelemente **31** befinden sich in neutraler Mittelstellung zwischen den Anschlägen **32** und **33.**

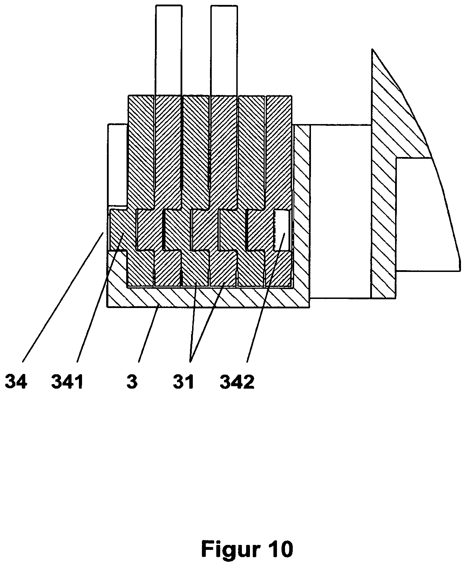

In der Figur 10 ist unter Verwendung gleicher Bezugszeichen für gleiche Mittel eine geschnittene Detaildarstellung einer kodierten Kodiereinrichtung des Anschlusselements **3** vergrößert dargestellt. In besonderer Ausgestaltung der Erfindung weisen die keilförmigen Kodeelemente **31** entlang der Drehachse **34** zapfenförmige Ausstülpungen **341** und auf der gegenüberliegenden Seite zu diesen Ausstülpungen **341** korrespondierende Ausnehmungen **342** auf, die derart ineinander greifen, dass sie gemeinsam eine segmentierte Drehachse **34** bilden.

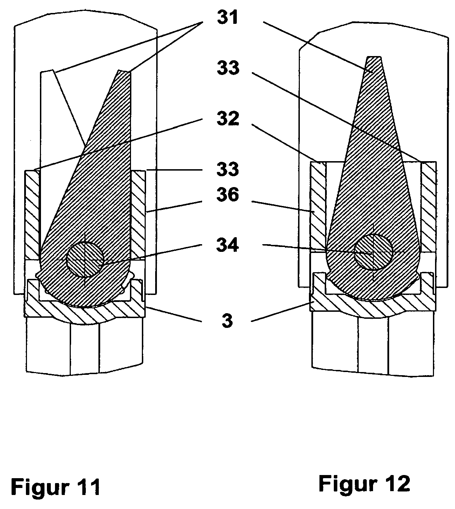

In der Figur 11 ist unter Verwendung gleicher Bezugszeichen für gleiche Mittel eine teilweise geschnittene Detaildarstellung einer kodierten Kodiereinrichtung des Anschlusselements **3** vergrößert dargestellt. Zum Vergleich ist in Figur 12 unter Verwendung gleicher Bezugszeichen für gleiche Mittel eine teilweise geschnittene Detaildarstellung einer initialen Kodiereinrichtung des Anschlusselements **3** vergrößert dargestellt. Unter gleichzeitiger Bezugnahme auf die Figuren 11 und 12 sind die keilförmigen Kodeelemente **31** des Anschlusselements **3** in einem Käfig **36** drehbar angeordnet. In bevorzugter Ausführungsform der Erfindung ist der Käfig **36** durch die Anschläge **32** und **33** begrenzt. Darüber hinaus weist der Käfig **36** Ausnehmungen **37** auf. Die keilförmigen Kodeelemente **31** weisen Rastnasen **38** auf.

In der initialen Ruhestellung der keilförmigen Kodeelemente **31** mittig zwischen den Anschlägen **32** und **33** gemäß Figur 12 arretieren die Rastnasen **38** die keilförmigen Kodeelemente **31** kraftschlüssig im Käfig **36.**

In der kodierten Stellung der keilförmigen Kodeelemente **31** gemäß Figur 11 greifen die Rastnasen **38** in die korrespondierenden Ausnehmungen **37** und arretieren die keilförmigen Kodeelemente **31** formschlüssig im Käfig **36.**

### Bezugszeichenliste

- 1: Grundplatte
- 11: Schraubklemme
- 2: Anschlusselement
- 21, 31: Kodeelement
- 22, 35: Auflagefläche
- 23: Seitenfläche
- 24: Ausnehmung
- 25: Erhebung
- 3: Steckeinheit
- 32, 33: Anschlagfläche
- 34: Drehachse
- 341: Ausstülpung
- 342, 37: Ausnehmung
- 36: Käfig
- 38: Rastnase

## Patentansprüche

1. Feldgeräteanschlusseinheit mit einer Grundplatte (1), auf der eine Mehrzahl von Anschlusselementen (3) zum Anschluss von Verbindungsleitungen mit Feldgeräten und eine Mehrzahl von Steckplätzen zur Aufnahme von jeweils einer Steckeinheit (2) verschiedener Steckeinheitentypen,
**dadurch gekennzeichnet,**
**dass** Steckeinheiten (2) desselben Steckeinheitentyps eine identische Typkodierung aufweisen, die durch eine Mehrzahl keilförmiger Kodeelemente (21) gebildet ist, welche starr in der Steckeinheit (2) verankert sind und jeder Steckplatz eine Mehrzahl keilförmiger Kodeelemente (31) aufweist, welche zwischen zwei gegenüberliegenden Anschlägen (32, 33) um eine Drehachse (34) beweglich gelagert sind und deren Keilspitzen in initialer Ruhestellung mittig zwischen den Anschlägen (32, 33) ausgerichtet sind.

2. Feldgeräteanschlusseinheit nach Anspruch 1
**dadurch gekennzeichnet,**
**dass** die keilförmigen Kodeelemente (21) der Steckeinheiten (2) asymmetrisch ausgebildet, wobei eine in die Keilspitze mündende Seitenfläche (23) jedes Kodeelements (21) in Steckrichtung ausgerichtet ist.

3. Feldgeräteanschlusseinheit nach einem der Ansprüche 1 und 2
**dadurch gekennzeichnet,**
**dass** die Keilspitzen der keilförmigen Kodeelemente (21, 31) unter Bildung einer Auflagefläche (22, 35) abgeflacht sind.

4. Feldgeräteanschlusseinheit nach einem der vorstehenden Ansprüche
**dadurch gekennzeichnet,**
**dass** die keilförmigen Kodeelemente (31) des Steckplatzes nach der initialen Kodierung durch die erste eingesteckte Steckeinheit (2) um die Drehachse (34) verschwenkt an einem der gegenüberliegenden Anschlägen (32, 33) anliegen.

5. Feldgeräteanschlusseinheit nach einem der vorstehenden Ansprüche
**dadurch gekennzeichnet,**
**dass** die keilförmigen Kodeelemente (31) des Steckplatzes in einem Käfig (36) geführt sind.

6. Feldgeräteanschlusseinheit nach Anspruch 5
**dadurch gekennzeichnet,**
**dass** die keilförmigen Kodeelemente (31) des Steckplatzes im initilen Ruhezustand kraftschlüssig und im kodierten Zustand formschlüssig arretiert sind.

7. Feldgeräteanschlusseinheit nach Anspruch 4
**dadurch gekennzeichnet,**
**dass** die keilförmigen Kodeelemente (31) des Steckplatzes korrespondierende Ausstülpungen (341) und Ausnehmungen (342) aufweisen, die eine segmentierte Drehachse (34) bilden.

## Claims

1. A field device connection unit includes a base plate (1) on which a plurality of connection elements (3) for connection of connecting lines with field devices and a plurality of plug-in positions for receiving in each case one plug-in unit (2) of different plug-in unit types, is **characterized in that** an identical type coding is assigned to the plug-in units (2) of the same plug-in unit type, which identical type coding is formed by a plurality of wedge-shaped code elements (21) which are anchored rigidly in the plug-in unit (2), and a plurality of wedge-shaped code elements (31) are assigned to each module slot, which wedge-shaped code elements are mounted moveably about an axis of rotation (34) between two opposite stops (32, 33) and whose wedge tips are oriented, in an initial rest position, centrally between the stops (32, 33).

2. Field device connection unit according to claim 1 is **characterized in that** the wedge-shaped code elements (21) of the plug-in units (2) are formed asymmetrically, wherein a side surface (23) of each code element (21) opening into the wedge tip is aligned in the plug-in direction.

3. Field device connection unit according to one of claims 1 and 2 is **characterized in that** the wedge tips of the wedge-shaped code elements (21, 31) are flattened to form a supporting surface (22, 35).

4. Field device connection unit according to one of the preceding claims is **characterized in that** the wedge-shaped code elements (31) of the plug-in position is placed after the initial coding on one of opposite stops (32, 33) pivoted by the first inserted plug-in unit (2) about the axis of rotation (34).

5. Field device connection unit according to one of the preceding claims is **characterized in that** the wedge-shaped code elements (31) of the module slot are guided in a cage (36).

6. Field device connection unit according to claim 5 **characterized in that** the wedge-shaped code elements (31) of the plug-in position are locked force-fit in the initial resting state and form-fit in the encoded state.

7. Field device connection unit according to claim 4 is **characterized in that** the wedge-shaped code elements (31) of the plug-in position have corresponding protuberances (341) and recesses (342) forming a segmented axis of rotation (34).

## Revendications

1. Unité de raccordement d'appareils de terrain avec une plaque de base (1), sur laquelle se trouvent une multitude d'éléments de raccordement (3) destinés au branchement de câbles de liaison d'appareils de terrain et une multitude d'emplacements destinés à accueillir chacun une unité enfichable (2) de types différents. Les unités enfichables (2) du même type sont identifiées de telle manière qu'elles présentent une codification de type identique, formée par une multitude d'éléments de codage de forme conique (31) solidement ancrés dans l'unité enfichable (2), et chaque emplacement présente une multitude d'éléments de codage de forme conique (31) montés sur un support mobile entre deux butées opposées (32, 33) autour d'un axe rotatif et dont la pointe conique en position de repos initiale est orientée au centre des deux butées (32, 33).

2. Unité de raccordement d'appareils de terrain conformément à la revendication 1, identifiée de telle manière que les éléments de codage de forme conique (21) des unités enfichables (2) sont positionnées de manière asymétrique, une face latérale (23) de chaque élément de codage (21) débouchant sur la pointe conique étant orientée dans le sens d'enfichage.

3. Unité de raccordement d'appareils de terrain conformément aux revendications 1 et 2, identifiée de telle manière que les pointes coniques des éléments de codage de forme conique (21, 31) sont aplaties pour former une surface d'appui (22, 35).

4. Unité de raccordement d'appareils de terrain conformément à l'une des revendications susmentionnées, identifiée de telle manière que les éléments de codage de forme conique (31) de l'emplacement, conformément à la codification initiale par la première unité enfichable (2) basculant autour de l'axe rotatif (34), reposent sur l'une des butées opposées (32, 33).

5. Unité de raccordement d'appareils de terrain conformément à l'une des revendications susmentionnées, identifiée de telle manière
que les éléments de codage de forme conique (31) de l'emplacement sont fixés dans une cage (36).

6. Unité de raccordement d'appareils de terrain conformément à la revendication 5, identifiée de telle manière que les éléments de codage de forme conique (31) de l'emplacement sont fermement bloquées en position de repos initiale et en position finale à l'état codé.

7. Unité de raccordement d'appareils de terrain conformément à la revendication 4, identifiée de telle manière que les éléments de codage de forme conique (31) de l'emplacement présentent des épaulements (341) et des évidements (342 formant un axe de rotation segmenté (34).
